(19) Europäisches Patentamt / European Patent Office / Office européen des brevets

(11) **EP 2 486 414 B1**

(12) **EUROPÄISCHE PATENTSCHRIFT**

(45) Veröffentlichungstag und Bekanntmachung des Hinweises auf die Patenterteilung:
**05.03.2014 Patentblatt 2014/10**

(21) Anmeldenummer: **10765958.3**

(22) Anmeldetag: **01.10.2010**

(51) Int Cl.:
***G01R 19/25*** (2006.01)

(86) Internationale Anmeldenummer:
**PCT/EP2010/006003**

(87) Internationale Veröffentlichungsnummer:
**WO 2011/042134 (14.04.2011 Gazette 2011/15)**

(54) **VERFAHREN UND VORRICHTUNG ZUR ERMITTLUNG EINER EINGANGSSPANNUNG AN EINER ORTSNETZSTATION EINES STROMNETZES**

METHOD AND DEVICE FOR DETERMINING AN INPUT VOLTAGE ON A LOCAL NETWORK STATION OF A POWER NETWORK

PROCÉDÉ ET DISPOSITIF POUR DÉTERMINER UNE TENSION D'ENTRÉE SUR UN POSTE DE RÉSEAU LOCAL D'UN RÉSEAU ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **09.10.2009 DE 102009048509**

(43) Veröffentlichungstag der Anmeldung:
**15.08.2012 Patentblatt 2012/33**

(73) Patentinhaber: **ABB Technology AG
8050 Zürich (CH)**

(72) Erfinder: **VON SENGBUSCH, Klaus
68259 Mannheim (DE)**

(74) Vertreter: **Kock, Ina et al
ABB AG
GF-IP
Wallstadter Straße 59
68526 Ladenburg (DE)**

(56) Entgegenhaltungen:
**DE-A1- 10 117 643**

- **TAE-EUNG KIM ET AL: "Considerations for the feasible operating range of distributed generation interconnected to power distribution system", 2002 IEEE POWER ENGINEERING SOCIETY. SUMMER MEETING. CONFERENCE PROCEEDINGS. CHICAGO, IL, JULY 21 - 25, 2002; [IEEE POWER ENGINEERING SOCIETY], NEW YORK, NY : IEEE, US, 25. Juli 2002 (2002-07-25), Seiten 42-48VOL.1, XP031212554, ISBN: 978-0-7803-7518-5**
- **MIKI A ET AL: "A Calculation Method for Impulse Voltage Distribution and Transferred Voltage in Transformer Windings", IEEE TRANSACTIONS ON POWER APPARATUS AND SYSTEMS, IEEE INC. NEW YORK, US, Bd. PAS-97, Nr. 3, 1. Mai 1978 (1978-05-01), Seiten 930-939, XP011180598, ISSN: 0018-9510, DOI: DOI:10.1109/TPAS. 1978.354566**

**Beschreibung**

Die Erfindung betrifft Energieverteilungstechnik, insbesondere Ortsnetzstationen, d.h. Umspannstationen, die Mittelspannungs- und Niederspannungsebene eines Stromnetzes miteinander verbinden. Insbesondere betrifft die Erfindung ein Verfahren zur Ermittlung der an der Ortsnetzstation anliegenden Mittelspannung.

Stromnetze für die Übertragung elektrischer Energie weisen in der Regel eine Reihe von Umspannstationen auf, die eine Höchstspannungsebene, eine Hochspannungsebene, eine Mittelspannungsebene und eine Niederspannungsebene miteinander verbinden. In der Vergangenheit wurde elektrische Energie von Kraftwerken zentral bereitgestellt, so dass die Richtung des Energieflusses in den Stromnetzen bekannt war, nämlich von der Hochspannungsebene zur Niederspannungsebene. Man konnte also bislang davon ausgehen, dass die Mittelspannung an einem Ausgang der Umspannstation zwischen der Hochspannungsebene und der Mittelspannungsebene am höchsten ist und diese in Richtung eines Eingangs einer Ortsnetzstation entsprechend abfällt. Mit der verstärkten Zunahme dezentraler Erzeugungsanlagen werden die Verteilungsnetze vor neue Herausforderungen gestellt. Im Zuge des Ausbaus erneuerbarer Energien werden zunehmend Kleinsterzeugungsanlagen an das Stromnetz angeschlossen, die elektrische Energie bereitstellen, die in die Mittelspannungsebene, insbesondere nahe der Ortsnetzstationen eingespeist wird. Dadurch können Belastungsspitzen durch Rückspeisung auftreten und Geräte bei Endkunden durch unzulässige Spannungsüberhöhungen schädigen.

Weiterhin kann in der Regel das Einspeiseverhalten der Kleinsterzeugungsanlagen, d.h. die Zuverlässigkeit und Menge der bereitgestellten Energie, wie beispielsweise bei Solaranlagen und dergleichen, nicht vorhergesagt werden. Es ist daher zukünftig notwendig, die Energieflüsse in dem Stromnetz, insbesondere in der Mittelspannungsebene besser zu überwachen. Um Aufschluss über die Energieflüsse und den Spannungsverlauf in den Mittelspannungsnetzen zu erhalten ohne alle Ortsnetzstationen mit Messtechnik auszustatten, ist eine Kenntnis der eingangsseitig an einigen Ortsnetzstationen anliegenden Mittelspannung notwendig. Ohne direkte Messung an den Ortsnetzstationen können jedoch die dort anliegenden Mittelspannungen nicht in einfacher Weise hergeleitet werden.

Darüber hinaus ist in vorhandenen Ortsnetzstationen üblicherweise keine Messtechnik installiert, mit der die eingangsseitig an der Ortsnetzstation anliegende Mittelspannung erfasst werden kann. Aufgrund der kompakten Bauweise der Ortsnetzstationen ist es in der Regel schwierig, eingangsseitig eine derartige Spannungsmessung nachzurüsten.

Weiterhin sind bei den vorhandenen Anlagen, die Leerlaufströme der Transformatoren der Ortsnetzstation unbekannt, wodurch ein Rückrechnen der eingangsseitig anliegenden Mittelspannung ausgehend von einer einfach messbaren und somit bekannten Spannung und einem einfach messbaren und somit bekannten Strom auf der Niederspannungsseite des Transformators nicht ohne Weiteres möglich ist. Auch kann die Transformatorstufenstellung, d.h. das Übersetzungsverhältnis des Transformators, gelegentlich manuell an veränderte Mitteispannungen angepasst werden, um auf Niederspannungsebene die gewünschte Netzspannung zu erreichen. Die automatische Erfassung einer Änderung einer Transformatorstufenstellung ist zwar möglich, aber aufwändig. Auch eine manuelle Nachführung ist problematisch, da Stufenstellungsänderungen üblicherweise nicht von dem Fachpersonal ausgeführt werden, das auch für eine Umparametrierung der lokalen Mess- und Automatisierungstechnik ausgebildet ist.

DE 101 17 643 A1 (MIELE & CIE, 5. Dezember 2002) offenbart ein Verfahren zur Ermittlung der Grösse einer Netzeingangsspannung in einer Schaltungsanordnung, in der diese zur Speisung einer elektrischen Last unter Verwendung eines Netzteiltransformators in eine Kleinspannung umgewandelt wird, durch Messung der sekundärseitigen Transformatorausgangsspannung und des sekundärseitigen Transformatorausgangsstroms.

Es ist Aufgabe der vorliegenden Erfindung, ein Verfahren und eine Vorrichtung zur Verfügung zu stellen, mit denen in einfacher Weise auch bei vorhandenen Ortsnetzstationen, insbesondere mit Transformatoren älterer Bauart, die Eingangsspannung an der Oberspannungsseite eines Transformators einer Ortsnetzstation ermittelt werden kann.

Diese Aufgabe wird durch das Verfahren zum Bestimmen einer Eingangsspannung eines Transformators gemäß Anspruch 1 sowie durch die Vorrichtung gemäß dem nebengeordneten Anspruch gelöst.

Vorteilhafte Ausgestaltungen sind in den abhängigen Ansprüchen angegeben.

Gemäß einem ersten Aspekt ist ein Verfahren zur Ermittlung einer Eingangsspannung eines Transformators einer Ortsnetzstation vorgesehen. Das Verfahren umfasst die folgenden Schritte:

- Messen eines Eingangsstroms des Transformators, eines Ausgangsstroms des Transformators, einer Ausgangsspannung des Transformators sowie eines Phasenwinkels zwischen Ausgangsstrom und Ausgangsspannung;

- Bestimmen des Übersetzungsverhältnisse der komplexen Admittanz, beispielsweise der Querglieder eines p-Ersatzschaltbildes des Transformators der Ortsnetzstation oder weiterer Werte, aus denen diese Admittanz ableitbar ist, mit Hilfe des gemessenen Eingangsstromes, des gemessenen Ausgangsstroms, der gemessenen Ausgangsspannung und des Phasenwinkels zwischen dem Ausgangsstrom und der Ausgangsspannung;

- Ermitteln der Eingangsspannung des Transformators der Ortsnetzstation auf der Basis des bestimmten Übersetzungsverhältnisses und der vorab bestimmten komplexen Admittanz, also des bestimmten Ersatzschaltbildes.

Eine Idee der vorliegenden Erfindung besteht darin, ohne Vorgabe des Übersetzungsverhältnisses, des Leerlaufstromes, der Eisenverluste und/oder auch der Kupferverluste des Transformators einer Ortsnetzstation oder durch Vorgabe von Größen, ausd denen sich der Leerlaufstrom des Transformators ableiten lässt, die eingangsseitig anliegende Eingangsspannung zu ermitteln. Dies kann durchgeführt werden, indem zunächst das Übersetzungsverhältnis und und im Falle der Nutzung eines p-Ersatzschaltbildes die Admittanz der Querglieder mit Hilfe der Größen der Ausgangsspannung des Transformators, des Eingangsstromes und des Ausgangsstromes bestimmt werden. Zusätzlich werden lediglich Transformatorkenndaten benötigt, die üblicherweise dem Typenschild des Transformators entnommen werden können, und aus denen sich das Längsglied des p -Ersatzschaltbildes des Transformators der Ortsnetzstation ermitteln lässt. Dies kann beispielsweise die relative Kurzschlussspannung des Transformators in Kombination mit dessen Bemessungsscheinleistung und dessen Bemessungsströmen sein.

Gemäß einer Ausführungsform einer Ausführungsform können die zunächst unbekannten Elemente des Ersatzschaltbildes des Transformators der Ortsnetzstation durch Lösen eines Gleichungssystems, das wenigstens drei Messwertsätze aus Eingangsstrom ($I_{OS}$) des Transformators, Ausgangsstrom ($I_{US}$) des Transformators und Ausgangsspannung ($U_{US}$) berücksichtigt, bestimmt werden. Im Falle des p-Ersatzschaltbildes sind die zunächst unbekannten Elemente die Querglieder $\underline{Y}$ und das Übersetzungsverhältnis ü.

Es kann weiterhin vorgesehen sein, dass mehr als drei der vorgenannten Messwertsätze, wie Eingangsstrom ($I_{OS}$) des Transformators, Ausgangsstrom ($I_{US}$) des Transformators und Ausgangsspannung ($U_{US}$) des Transformators, verwendet werden, die zu einem überbestimmten Gleichungssystem führen, das z.B. mit Hilfe des mathematischen Verfahrens der nicht-linearen Zustandsschätzung gelöst werden kann.

Gemäß einem weiteren Aspekt ist eine Mess- und Überwachungseinheit zur Ermittlung einer Eingangsspannung eines Transformators einer Ortsnetzstation vorgesehen. Die Mess- und Überwachungseinheit umfasst:

- eine Spannungsmesseinheit zum Messen einer Ausgangsspannung;

- Strommesseinheiten zum Messen eines Eingangsstroms des Transformators und eines Ausgangsstroms des Transformators;

- eine Phasendifferenzeinheit zum Bestimmen eines Phasenwinkels zwischen Ausgangsstrom und Ausgangsspannung;

- eine Berechnungseinheit, die ausgebildet ist,

    o um das Übersetzungsverhältnis und die Admittanz eines Quergliedes eines p-Ersatzschaltbildes des Transformators der Ortsnetzstation mit Hilfe des gemessenen Eingangsstromes, des gemessenen Ausgangsstroms, der gemessenen Ausgangsspannung und des Phasenwinkels zwischen dem Ausgangsstrom und der Ausgangsspannung zu bestimmen;

    o um die Eingangsspannung des Transformators der Ortsnetzstation auf der Basis des bestimmten Übersetzungsverhältnisses und der Admittanz, beispielsweise des Quergliedes des p-Ersatzschaltbildes, zu ermitteln.

Bevorzugte Ausführungsformen werden nachfolgend anhand der beigefügten Zeichnungen näher erläutert. Es zeigen:

Figur 1    eine schematische Darstellung eines Stromnetzes mit verschiedenen Spannungsebenen;
Figur 2    eine schematische Darstellung einer Umspannvorrichtung, insbesondere einer Ortsnetzstation; und
Figur 3    ein Ersatzschaltbild eines Transformators einer Ortsnetzstation.

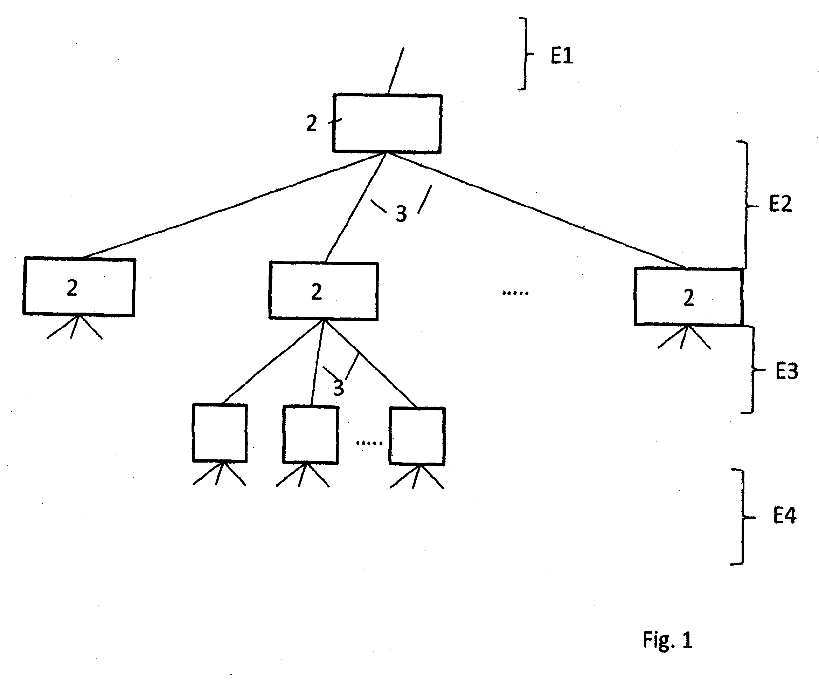

In **Figur 1** ist schematisch ein Stromnetz 1 mit Übertragungsleitungen 3 dargestellt, das eine Höchstspannungsebene E1, eine Hochspannungsebene E2, eine Mittelspannungsebene E3 und eine Niederspannungsebene E4 aufweist. Die Übertragungsleitungen werden der Einfachheit halber als einfache Linien dargestellt, obwohl in der Regel mehrere Übertragungsleitungen zum Übertragen des Stromes vorgesehen sind. Zwischen den Spannungsebenen E1 bis E4 sind Umspannstationen 2 vorgesehen, die als Hauptkomponente einen Transformator aufweisen, um die Spannungen von einer Ebene höherer Spannung zu einer Ebene niedrigerer Spannung zu transformieren. Umspannstationen zwischen der Mittelspannungsebene E3 und der Niederspannungsebene E4 werden Ortsnetzstationen genannt.

Während die Umspannstationen 2 zwischen der Höchstspannungsebene E1 und der Hochspannungsebene E2 sowie zwischen der Hochspannungsebene E2 und der Mittelspannungsebene E3 aufgrund auf ihrer vergleichsweise geringeren Anzahl und ihrer größeren Bauart einfach mit entsprechenden Messvorrichtungen zur Messung der eingangs- und ausgangsseitigen Spannungen (Eingangsspannung und Ausgangsspannung) versehen werden können, ist dies bei den Ortsnetzstationen schon aufgrund ihrer hohen Anzahl nur mit erhöhtem Aufwand zu erreichen. Zudem sind die Ortsnetzstationen üblicherweise kompakt aufgebaut und das Vorsehen einer eingangsseitigen Spannungsmessung ist dadurch in der Regel, insbesondere bei vorhandenen Anlagen, schwierig.

Bislang war es üblich, für die Mittelspannungsebene nur eine oder nur wenige Einspeisungsstellen vorzusehen. Die Einspeisungsstelle kann beispielsweise in Fig. 1 einer Umspannstation 2 zwischen der Hochspannungsebene E2 und der Mittelspannungsebene E3 entsprechen. Die Spannung in der Mittelspannungsebene E3 ist an dieser Einspeisestelle am höchsten und fällt mit zunehmender Entfernung zur Einspeisestelle ab. Die Richtung des Energieflusses war stets bekannt. Diese Situation ändert sich zusehends, da durch Hinzuschalten von dezentralen Erzeugungsanlagen, beispielsweise aus regenerativen Energiequellen, Strom- und Spannungsverteilung in der Mittelspannungsebene schwer vorhersagbar werden. Dies ist insbesondere dann der Fall, wenn die Verfügbarkeit der dezentralen Erzeugungsanlage nicht vorhersagbar ist, wie dies beispielsweise bei Windkraft- oder Solaranlagen der Fall ist.

Um den Zustand der Mittelspannungsebene E3 jedoch überwachen zu können, ist die Kenntnis der über die Eingangsseite an den Ortsnetzstationen anliegenden Eingangsspannung hilfreich, da diese Spannung nicht nur Informationen über die gemessene Station enthält, sondern auch Informationen über die benachbarten Stationen. Auf diese Weise kann mit wenigen Messungen innerhalb eines Mittelspannungsabgangs in Kombination mit den ohnehin verfügbaren Messungen in der speisenden Station bereits relativ genau auf dessen Zustand geschlossen werden.

Insbesondere kann eine zu hohe Eingangsspannung $U_{OS}$ an der Eingangsseite der Ortsnetzstationen problematisch sein, da dies aufgrund des quasi nicht variablen Übersetzungsverhältnisses des Transformators der Ortsnetzstation zu einer zu erhöhten Netzspannung (Niederspannung) führen würde, die an die Verbraucher geliefert wird. Diese kann Schäden an angeschlossenen Endgeräten hervorrufen oder deren Lebensdauer verringern.

Anstelle einer direkten Messung der oberspannungsseitig anliegenden Eingangsspannung ließe sich durch Messung der ausgangsseitig an den Transformatoren der Ortsnetzstationen 2 anliegenden Ausgangsspannung $U_{US}$ und des ausgangsseitig fließenden Ausgangsstroms $I_{US}$ mit Hilfe von elektrischen Kenngrößen des Transformators (ü: Übersetzungsverhältnis, d.h. das Verhältnis der Anzahl der primärseitigen Windungen zu der Anzahl der sekundärseitigen Windungen, $\underline{Y}$: Querglieder eines p-Ersatzschaltbildes des Transformators) die oberspannungsseitig anliegende Eingangsspannung ermitteln, jedoch sind insbesondere gerade bei älteren Ortsnetzstationen nicht alle elektrischen Kenngrößen bekannt, die dafür erforderlich sind. Dies betrifft insbesondere die Leerlaufverluste. Auch sind genaue Angaben über das Übersetzungsverhältnis ü und die Querglieder $\underline{Y}$ des p-Ersatzschaltbildes nicht verfügbar. Lediglich eine Information über die relative Kurzschlussspannung $u_K$, eine oberspannungsseitige Bemessungsspannung $U_{OSr}$, eine unterspannungsseitige Bemessungsspannung sowie einen Bemessungsstrom sind in der Regel auf Typenschildern an den Transformatoren in den Ortsnetzstationen immer angegeben, so dass diese als bekannt vorausgesetzt werden können. Die relative Kurzschlussspannung $u_K$ bei Transformatoren ist die Spannung, die bei kurzgeschlossener Sekundärwicklung an der Primärwicklung anliegen muss, damit die Primärwicklung einen Bemessungsstrom aufnimmt. Es gilt:

$$u_k = U_k \cdot 100\% \ / \ U_{OSr},$$

wobei $U_k$ der gemessenen Kurzschlussspannung und $U_{OSr}$ der oberspannungsseitigen Bemessungsspannung entsprechen.

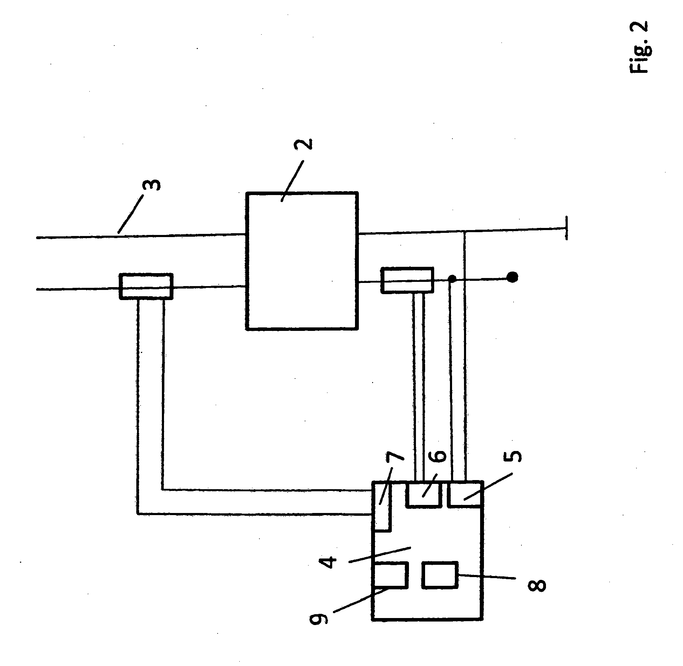

In **Figur 2** ist ein System mit einer Umspannvorrichtung 2, insbesondere einer Umspannvorrichtung einer Ortsnetzstation, dargestellt, die mit einer Mess- und Überwachungseinheit 4 gekoppelt ist. Die Mess- und Überwachungseinheit 4 misst ausgangsseitig eine Ausgangsspannung der Umspannvorrichtung 2 mit Hilfe einer Spannungsmesseinheit 5 und einen Ausgangsstrom der Umspannvorrichtung 2 mit einer ersten Strommesseinheit 6 und den eingangsseitig in die Umspannvorrichtung 2 fließenden Strom mit Hilfe einer zweiten Strommesseinheit 7.

Die Strommesseinheiten 6, 7 können als Stromwandler ausgebildet sein und so genannte Kabelumbauwandler umfassen, die eine oder mehrere Wicklungen um den betreffenden Leiter aufweisen, in dem ein fließender Strom gemessen werden soll. In der Wicklung wird eine Messspannung induziert, der proportional zu dem Stromfluss in dem Leiter ist. In der Mess- und Überwachungseinheit 4 werden die von den Stromwandlern bereitgestellten Messspannungen mit Hilfe der Strommesseinheiten 6, 7 gemessen und es werden in der Mess- und Überwachungseinheit 4 entsprechende Angaben über die in die Eingangsseite und die Ausgangsseite des Transformators der Umspannstation 2 fließenden Eingangsstrom $I_{OS}$ und Ausgangsstrom $I_{US}$ bereitgestellt. Mit Hilfe einer Berechnungseinheit 9 werden die nachfolgenden Berechnungen durchgeführt, um die Eingangsspannung $U_{OS}$ zu ermitteln

Weiterhin wird eine Ausgangsspannung Uus an der Ausgangsseite der Umspannstation 2 durch die Spannungsmesseinheit 5 der Mess- und Überwachungseinheit 4 gemessen. Die Spannungsmessung kann beispielsweise mit einem herkömmlichen Analog-Digital-Wandler durchgeführt werden. Aus der gemessenen Ausgangsspannung $U_{US}$

und dem Ausgangsstrom $I_{US}$ wird ein Phasenversatz in einem Phasendifferenzdetektor 8 ermittelt und als Phasenwinkeldifferenz φ zwischen Ausgangsspannung $U_{US}$ und dem Ausgangsstrom $I_{US}$ bereitgestellt

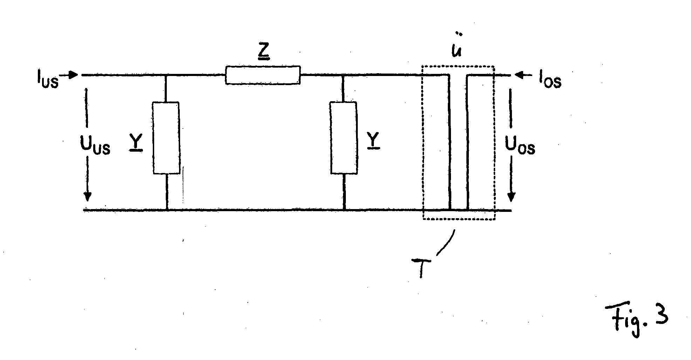

In **Figur 3** ist das p-Ersatzschaltbild des Transformators der Ortsnetzstation 2 dargestellt. Das p-Ersatzschaltbild sieht einen idealen Transformator T vor, der eingangsseitig um eine p-Schaltung aus zwei Quergliedern $\underline{Y}$ und einem Längsglied $\underline{Z}$ erweitert ist. Ein erstes Querglied verbindet die Eingangsanschlüsse des Transformators der Ortsnetzstation miteinander. Ein zweites Querglied mit einer identischen Admittanz $\underline{Y}$ verbindet die Eingangsanschlüsse des idealen Transformators T miteinander. Zwischen den so parallel zu dem idealen Transformator angeordneten Quergliedern ist das Längsglied seriell angeordnet.

Während der Betrag der Impedanz $\underline{Z}$ des Längsgliedes aus der relativen Kurzschlussspannung $u_k$ bestimmt werden kann und dieser bei Transformatoren in Ortsnetzstationen - wenn beispielsweise keine Informationen über die Kupferverluste vorliegen - vereinfachend als rein induktiv angenommen werden kann, ist die Admittanz $\underline{Y}$ der Querglieder zunächst unbekannt. Die Stufung des Transformators und damit das Übersetzungsverhältnis ü wird ebenfalls als unbekannt vorausgesetzt, da die Stufenstellung geändert werden kann ohne das die Sekundärtechnik in der Station davon Kenntnis erlangt.

In der Mess- und Überwachungseinheit 4 werden die nicht bekannten Admittanzen $\underline{Y}$ der Querglieder des Transformators und dessen Übersetzungsverhältnis ü aus dem Eingangsstrom $I_{OS}$, dem Ausgangsstrom $I_{US}$ und der Ausgangsspannung, $U_{US}$ sowie der als bekannt vorausgesetzten Impedanz $\underline{Z}$ des Längsgliedes ermittelt. Dazu werden mindestens drei Messwertsätze, bestehend aus dem Eingangsstrom $I_{OS}$, der Ausgangsspannung $U_{US}$, dem Ausgangsstrom $I_{US}$ und der Phasenwinkeldifferenz φ zwischen der Ausgangsspannung $U_{US}$ und dem Ausgangsstrom $I_{US}$, zu Zeitpunkten mit verschiedener Belastung benötigt. Bessere Ergebnisse werden bei Verwendung einer höheren Zahl von Messwertsätzen erzielt, da so die Folgen von Messfehlern reduziert werden können.

Eine Möglichkeit ü und $\underline{Y}$ gemeinsam zu bestimmen, besteht in der Lösung der folgenden Gleichung, die auf dem p-Ersatzschaltbild gemäß Figur 3 basiert:

$$\left|\frac{\underline{I}_{OS}}{\underline{I}_{US}}\right| = \left|\underline{A} \cdot \frac{\underline{U}_{US}}{\underline{I}_{US}} + \underline{B}\right| \text{ mit } \underline{A} = \underline{Y} \cdot (2 + \underline{Z} \cdot \underline{Y}) \cdot \ddot{u} \text{ und } \underline{B} = \frac{1 + \underline{Z} \cdot \underline{Y}}{\ddot{u}}$$

In der Gleichung sind die Größen $\underline{Y}$ und ü unbekannt. Da sich $\underline{Y}$ aus einem Realteil $Y_r$ und einem Imaginärteil $Y_i$ zusammensetzt, entspricht dies drei realen unbekannten Variablen $Y_r$, $Y_i$ und ü. Der Betrag des Verhältnisses von $\underline{I}_{OS}$ und $\underline{I}_{US}$ der Gleichung ist durch die beiden Strommessungen bekannt. Ebenfalls bekannt ist das komplexe Verhältnis von $\underline{U}_{US}$ und $\underline{I}_{US}$ im rechten Teil der Gleichung. Während sich Ströme und Spannungen zu verschiedenen Belastungssituationen ändern, sind alle anderen Elemente der Gleichung konstant. Erst durch Auswertung der Gleichung zu drei verschiedenen Zeitpunkten ergibt sich ein lösbares Gleichungssystem.

Da die Messwerte der Messwertsätze in der Praxis mit Fehlern behaftet sind, werden nicht nur die minimal erforderlichen drei Messwertsätze zur Berechnung herangezogen, sondern deutlich mehr, wie beispielsweise 100. Auf diese Weise ist eine Schätzung der elektrischen Parameter der Elemente des Ersatzschaltbilds mit hoher Genauigkeit auf der Basis des bekannten mathematischen Verfahrens einer nicht linearen Zustandsschätzung (non-linear state estimation) möglich. Bei diesem Verfahren wird bei einem überbestimmten Gleichungssystem die wahrscheinlichste Lösung gefunden. Insbesondere können in bekannter Weise die Querglieder $\underline{Y}$ und das Übersetzungsverhältnis ü aus einem stark überbestimmten Gleichungssystem ermittelt werden, so dass sich bei Einsetzen der Messwerte der Messwertsätze insgesamt die kleinste mögliche Abweichung für die zu bestimmenden Größen ergibt. Sind die Parameter Admittanz $\underline{Y}$ und das Übersetzungsverhältnis ü auf diese Weise bestimmt, kann anschließend bei Aufnahme jedes neuen Messwertsatzes direkt die Eingangsspannung $U_{OS}$ an der Oberspannungsseite des Transformators ermittelt werden.

Da auch der Eingangsstrom $I_{OS}$ berechnet werden kann, dieser aber auch zusätzlich gemessen wird, ist eine regelmäßige Überprüfung der Qualität der Berechnung im beschriebenen Verfahren enthalten. Beispielsweise kann bei einer Abweichung zwischen gemessenem und berechnetem Eingangsstrom $I_{OS}$ über einen bestimmten Stromschwellenwert ein erneutes Verfahren zur Ermittlung der komplexen Admittanzen $\underline{Y}$ und des Übersetzungsverhältnisses ü gestartet werden, um diese Werte zu korrigieren. Beispielsweise kann ein solcher Fall auftreten, wenn eine Stufenstellung des Transformators der Ortsnetzstation geändert worden ist.

Bezugszeichenliste

| | |
|---|---|
| 1 | Stromnetz |
| 2 | Umspannstation |
| 3 | Übertragungsleitungen |
| 4 | Mess- und Überwachungseinheit |
| 5 | Spannungsmesseinheit |
| 6, 7 | Strommesseinheiten |
| 8 | Phasendifferenzdetektor |
| 9 | Berechnungseinheit |
| $U_k$ | relative Kurzschlussspannung |
| $U_k$ | Kurzschlussspannung |
| $\underline{Y}$ | komplexe Admittanz der Querglieder, beispielsweise im p-Ersatzschaltbild des Transformators |
| $\underline{Z}$ | komplexe Impedanz des Längsglieds, beispielsweise im p-Ersatzschaltbild des Transformators |
| $U_{US}$ | Ausgangsspannung |
| $I_{US}$ | Ausgangsstrom |
| $U_{OS}$ | Eingangsspannung |
| $I_{OS}$ | Eingangsstrom |
| $U_{OSr}$ | Bemessungsspannung an der Oberspannungsseite des Transformators |

**Patentansprüche**

1. Verfahren zur Ermittlung einer Eingangsspannung eines Transformators einer Ortsnetzstation (2), mit folgenden Schritten:

   - Messen eines Eingangsstroms ($I_{OS}$) des Transformators, eines Ausgangsstroms ($I_{US}$) des Transformators, einer Ausgangsspannung ($U_{US}$) des Transformators sowie eines Phasenwinkels zwischen Ausgangsstrom ($I_{US}$) und Ausgangsspannung ($U_{US}$);
   - Bestimmen des Übersetzungsverhältnisses (ü) und der komplexen Admittanzen ($\underline{Y}$) von Quergliedern, beispielsweise eines p-Ersatzschaltbildes, des Transformators der Ortsnetzstation (2) mit Hilfe des gemessenen Eingangsstromes ($I_{OS}$), des gemessenen Ausgangsstroms ($I_{US}$), der gemessenen Ausgangsspannung ($U_{US}$) und des Phasenwinkels zwischen dem Ausgangsstrom ($I_{US}$) und der Ausgangsspannung ($U_{US}$); und
   - Ermitteln der Eingangsspannung ($U_{OS}$) des Transformators der Ortsnetzstation (2) auf der Basis des bestimmten Übersetzungsverhältnisses (ü) und der bestimmten Admittanzen ($\underline{Y}$) der Querglieder, beispielsweise des p-Ersatzschaltbildes.

2. Verfahren nach Anspruch 1, wobei das Bestimmen des Übersetzungsverhältnisses (ü) und der Admittanzen ($\underline{Y}$) der Querglieder mittels Angaben zu einer oberspannungsseitigen Bemessungsspannung, zu einer relativen Kurzschlussspannung ($u_k$) und zu einem oberspannungsseitigen Bemessungsstrom durchgeführt wird.

3. Verfahren nach Anspruch 1 oder 2, wobei das Übersetzungsverhältnis (ü) und die Admittanzen ($\underline{Y}$) durch Lösen eines Gleichungssystems bestimmt werden, wobei das Gleichungssystem mit Hilfe einer Übertragungsmatrix des p-Ersatzschaltbildes ermittelt wird.

4. Verfahren nach Anspruch 3, wobei das Gleichungssystem überbestimmt ist und mit Hilfe einer nicht-linearen Zustandsschätzung gelöst wird.

5. Verfahren nach Anspruch 4, wobei mehrere, vorzugsweise mehr als drei, Messwertsätze aus Eingangsstrom ($I_{OS}$) des Transformators, Ausgangsstrom ($I_{US}$) des Transformators und Ausgangsspannung ($U_{US}$) des Transformators bestimmt werden, die die Überbestimmtheit des Gleichungssystems erhöhen.

6. Verfahren nach Anspruch 3 oder 4, wobei das p-Ersatzschaltbild zwei parallele Querglieder mit Admittanzen ($\underline{Y}$) vorsieht, zwischen denen ein Längsglied mit einer Impedanz ($\underline{Z}$) seriell angeordnet ist, wobei ein Imaginäranteil der Impedanz ($\underline{Z}$) näherungsweise durch Ermitteln des Betrages der Impedanz ($\underline{Z}$) bestimmt wird.

7. Verfahren nach Anspruch 3 oder 4, wobei das p-Ersatzschaltbild zwei parallele Querglieder mit Admittanzen ($\underline{Y}$) vorsieht, zwischen denen ein Längsglied mit einer Impedanz ($\underline{Z}$) seriell angeordnet ist, wobei die Impedanz ($\underline{Z}$) aus relativer oder absoluter Kurzschlussspannung und Kupferverlusten bestimmt wird.

8. Mess- und Überwachungseinheit (4) zur Ermittlung einer Eingangsspannung eines Transformators einer Ortsnetzstation (2), umfassend:

- eine Spannungsmesseinheit (5) zum Messen einer Ausgangsspannung ($U_{US}$);
- Strommesseinheiten (6, 7) zum Messen eines Eingangsstroms ($I_{OS}$) des Transformators und eines Ausgangsstroms ($I_{US}$) des Transformators;
- eine Phasendifferenzeinheit zum Bestimmen eines Phasenwinkels zwischen Ausgangsstrom ($I_{US}$) und Ausgangsspannung ($U_{US}$);
- eine Berechnungseinheit (9), die ausgebildet ist,

○ um das Übersetzungsverhältnis (ü) und eine Admittanz (Y) von Quergliedern, beispielsweise eines p-Ersatzschaltbildes, des Transformators der Ortsnetzstation (2) mit Hilfe des gemessenen Eingangsstromes ($I_{OS}$), des gemessenen Ausgangsstroms ($I_{US}$), der gemessenen Ausgangsspannung ($U_{US}$) und des Phasenwinkels zwischen dem Ausgangsstrom ($I_{US}$) und der Ausgangsspannung ($U_{US}$) zu bestimmen; und
○ um die Eingangsspannung ($U_{OS}$) des Transformators der Ortsnetzstation (2) auf der Basis des bestimmten Übersetzungsverhältnisses (ü) und der bestimmten Admittanz (Y) des Quergliedes des p-Ersatzschaltbildes zu ermitteln.

**Claims**

1. Method for determination of an input voltage of a transformer in a local network station (2) having the following steps:

- measuring of an input current ($I_{OS}$) of the transformer, of an output current ($I_{US}$) of the transformer, of an output voltage *($U_{US}$)* of the transformer and of a phase angle between the output current ($I_{US}$) and the output voltage ($U_{US}$);
- determination of the transformation ratio (ü) and of the complex admittances ($\underline{Y}$) of parallel elements, for example of a p-equivalent circuit, of the transformer in the local network station (2) with the aid of the measured input current ($I_{OS}$), of the measured output current ($I_{US}$), of the measured output voltage *($U_{US}$)* and of the phase angle between the output current ($I_{US}$) and the output voltage *($U_{US}$)*; and
- determination of the input voltage ($U_{OS}$) of the transformer in the local network station (2) on the basis of the determined transformation ratio (ü) and of the determined admittances ($\underline{Y}$) of the parallel elements, for example of the p-equivalent circuit.

2. Method according to Claim 1, wherein the transformation ratio (ü) and the admittances ($\underline{Y}$) of the parallel elements are determined by means of statements relating to a rated voltage on the high-voltage side, relating to a relative short-circuit voltage ($u_k$), and relating to a rated current on the high-voltage side.

3. Method according to Claim 1 or 2, wherein the transformation ratio (ü) and the admittances ($\underline{Y}$) are determined by solving an equation system, wherein the equation system is determined with the aid of a transformation matrix of the p-equivalent circuit.

4. Method according to Claim 3, wherein the equation system is overdefined, and is solved with the aid of a non-linear state estimation.

5. Method according to Claim 4, wherein a plurality of measured-value sets, preferably more than three, of the input current ($I_{OS}$) of the transformer, of the output current ($I_{US}$) of the transformer and of the output voltage ($U_{US}$) of the transformer are determined, which increase the overdefinition of the equation system.

6. Method according to Claim 3 or 4, wherein the p-equivalent circuit provides two parallel elements with admittances ($\underline{Y}$), between which a series element with an impedance ($\underline{Z}$) is arranged in series, wherein an imaginary part of the impedance ($\underline{Z}$) is determined approximately by determination of the magnitude of the impedance ($\underline{Z}$).

7. Method according to Claim 3 or 4, wherein the p-equivalent circuit provides two parallel elements with admittances ($\underline{Y}$), between which a series element with an impedance ($\underline{Z}$) is arranged in series, wherein the impedance ($\underline{Z}$) is determined from the relative or absolute short-circuit voltage and copper losses.

8. Measurement and monitoring unit (4) for determination of an input voltage of a transformer in a local network station (2), comprising:

- a voltage measurement unit (5) for measurement of an output voltage ($U_{US}$);
- current measurement units (6, 7) for measurement of an input current ($I_{OS}$) of the transformer and of an output current ($I_{US}$) of the transformer;
- a phase difference unit for determination of a phase angle between the output current ($I_{US}$) and the output voltage ($U_{US}$);
- a calculation unit (9), which is designed

○ in order to determine the transformation ratio (ü) and an admittance (Y) of parallel elements, for example of a p-equivalent circuit, of the transformer in the local network station (2) with the aid of the measured input current ($I_{OS}$), of the measured output current ($I_{US}$), of the measured output voltage ($U_{US}$) and of the phase angle between the output current ($I_{US}$) and the output voltage ($U_{US}$); and
○ in order to determine the input voltage ($U_{OS}$) of the transformer in the local network station (2) on the basis of the determined transformation ratio (ü) and of the determined admittance (Y) of the parallel element in the p-equivalent circuit.

## Revendications

1. Procédé destiné à déterminer une tension d'entrée d'un transformateur d'une station de réseau local (2), comprenant les étapes suivantes :

   - la mesure d'un courant d'entrée ($I_{OS}$) du transformateur, d'un courant de sortie ($I_{US}$) du transformateur, d'une tension de sortie ($U_{US}$) du transformateur et d'un angle de phase entre le courant de sortie ($I_{US}$) et la tension de sortie ($U_{US}$) ;
   - la détermination du rapport de transformation (ü) et des admittances complexes ($\underline{Y}$) d'éléments transversaux, par exemple d'un schéma de circuit p-équivalent, du transformateur de la station de réseau local (2) à l'aide du courant d'entrée ($I_{OS}$) mesuré, du courant de sortie ($I_{US}$) mesuré, de la tension de sortie ($U_{US}$) mesurée et de l'angle de phase entre le courant de sortie ($I_{US}$) et la tension de sortie ($U_{US}$) ; et
   - l'obtention de la tension d'entrée ($U_{OS}$) du transformateur de la station de réseau local (2) sur la base du rapport de transformation (ü) déterminé et des admittances spécifiques ($\underline{Y}$) des éléments transversaux, par exemple du schéma de circuit p-équivalent.

2. Procédé selon la revendication 1, dans lequel la détermination du rapport de transformation (ü) et des admittances ($\underline{Y}$) des éléments transversaux est effectuée au moyen de données concernant une tension nominale côté haute tension, une tension de court-circuit relative ($u_k$) et un courant nominal côté haute tension.

3. Procédé selon la revendication 1 ou 2, dans lequel le rapport de transformation (ü) et les admittances ($\underline{Y}$) sont déterminés par résolution d'un système d'équations, dans lequel le système d'équations est obtenu à l'aide d'une matrice de transmission du schéma de circuit p-équivalent.

4. Procédé selon la revendication 3, dans lequel le système d'équations est surdéterminé et est résolu à l'aide d'une estimation d'état non linéaire.

5. Procédé selon la revendication 4, dans lequel on détermine une pluralité, de préférence plus de trois, ensembles de valeurs de mesure constitués du courant d'entrée ($I_{os}$) du transformateur, du courant de sortie ($I_{US}$) du transformateur et de la tension de sortie ($U_{US}$) du transformateur, qui augmentent la surdétermination du système d'équations.

6. Procédé selon la revendication 3 ou 4, dans lequel le schéma de circuit p-équivalent fournit deux éléments transversaux parallèles ayant des admittances ($\underline{Y}$), entre lesquels un élément longitudinal ayant une impédance ($\underline{Z}$) est disposé en série, dans lequel une partie imaginaire de l'impédance ($\underline{Z}$) est déterminée de manière approximative par obtention de la valeur de l'impédance ($\underline{Z}$).

7. Procédé selon la revendication 3 ou 4, dans lequel le schéma de circuit p-équivalent fournit deux éléments transversaux parallèles ayant des admittances ($\underline{Y}$), entre lesquels un élément longitudinal ayant une impédance ($\underline{Z}$) est disposé en série, dans lequel l'impédance ($\underline{Z}$) est déterminée à partir d'une tension de court-circuit relative ou absolue et de pertes du cuivre.

8. Unité de mesure et de surveillance (4) destinée à obtenir une tension d'entrée d'un transformateur d'une station de réseau local (2), comprenant :

- une unité de mesure de tension (5) destinée à mesurer une tension de sortie ($U_{US}$) ;
- des unités de mesure de courant (6, 7) destinées à mesurer un courant d'entrée ($I_{OS}$) du transformateur et un courant de sortie ($I_{US}$) du transformateur ;
- une unité de différence de phase destinée à déterminer un angle de phase entre le courant de sortie ($I_{US}$) et la tension de sortie ($U_{US}$) ;
- une unité de calcul (9) qui est conçue pour :

○ déterminer le rapport de transformation (ü) et une admittance (Y) d'éléments transversaux, par exemple d'un schéma de circuit p-équivalent, du transformateur de la station de réseau local (2) à l'aide du courant d'entrée ($I_{OS}$) mesuré, du courant de sortie ($I_{US}$) mesuré, de la tension de sortie ($U_{US}$) mesurée et de l'angle de phase entre le courant de sortie ($I_{US}$) et la tension de sortie ($U_{US}$) ; et
○ obtenir la tension d'entrée ($U_{OS}$) du transformateur de la station de réseau local (2) sur la base du rapport de transformation (ü) déterminé et de l'admittance (Y) déterminée de l'élément transversal du schéma de circuit p-équivalent.

Fig. 1

Fig. 2

Fig. 3

**IN DER BESCHREIBUNG AUFGEFÜHRTE DOKUMENTE**

**In der Beschreibung aufgeführte Patentdokumente**

- DE 10117643 A1